# EUROPÄISCHE PATENTANMELDUNG

(11) **EP 2 163 660 A1**
(43) Veröffentlichungstag der Anmeldung: **17.03.2010**
(21) Anmeldenummer: 09011441.4
(22) Anmeldetag: 07.09.2009
(51) Int. Cl.: C23C 14/02, G02B 6/122, G02B 6/132

(54) **Verfahren zur Herstellung einer optischen Wellenleiterschicht**

(30) Priorität: 10.09.2008 DE 102008046579
(71) Anmelder: Fraunhofer-Gesellschaft zur Förderung der angewandten Forschung e.V., 80686 München (DE)
(72) Erfinder: Bollwahn, Nancy, 07745 Jena (DE); Schulz, Ulrike, 07751 Jena (DE); Munzert, Peter, 07743 Jena (DE); Kaiser, Norbert, 07745 Jena (DE)
(74) Vertreter: Epping - Hermann - Fischer

(57) **Zusammenfassung**

Bei einem Verfahren zur Herstellung einer optischen Wellenleiterschicht (3) wird ein Substrat (4) bereitgestellt, auf das zunächst eine erste Teilschicht (1) aufgewachsen wird. Nachfolgend wird eine zweite Teilschicht (2) der Wellenleiterschicht (3), die aus dem gleichen Material wie die erste Teilschicht (1) gebildet ist, auf die erste Teilschicht (1) aufgewachsen. Die zweite Teilschicht (2) wird während des Aufwachsens mit Ionen (5) beschossen. Das Verfahren ermöglicht die Herstellung optischer Wellenleiterschichten auf temperaturempfindlichen Polymersubstraten.

## Beschreibung

Die Erfindung betrifft ein Verfahren zur Herstellung einer optischen Wellenleiterschicht.

Diese Patentanmeldung beansprucht die Priorität der deutschen Patentanmeldung 10 2008 046 579.8, deren Offenbarungsgehalt hiermit durch Rückbezug aufgenommen wird.

Schichten mit Wellenleitereigenschaften werden insbesondere für so genannte Biochips benötigt, insbesondere für Anwendungen in der medizinischen Diagnostik, zum Beispiel zur DNA-Analyse oder Antikörperbestimmung, und in der Gentechnik. Ein optischer Wellenleiter kann insbesondere dadurch erzeugt werden, dass auf ein Substrat eine Schicht mit einem höheren Brechungsindex aufgebracht wird.

Optische Wellenleiterschichten sollten vorzugsweise eine niedrige Dämpfung aufweisen. Beim Aufwachsen auf Glas werden hochbrechende Schichten mit einer niedrigen Dämpfung dadurch erzielt, dass die Beschichtung bei einer hohen Substrattemperatur erfolgt, so dass das natürliche Säulenwachstum der Schichten, welche die Lichtausbreitung in der Schicht behindert, vermindert wird.

Die zur Erzeugung von optischen Wellenleiterschichten auf Glas eingesetzten Beschichtungsverfahren sind in der Regel mit einem hohen Energieeintrag in das Substrat verbunden, bei denen die Substrattemperatur einen Wert von 100 °C leicht überschreiten kann.

Substrattemperaturen von über 100 °C sind aber für einige temperaturempfindliche Kunststoffsubstrate nicht geeignet. Andererseits wäre es aber wünschenswert, optische Wellenleiterschichten auf Kunststoffsubstraten herzustellen, da diese wesentlich kostengünstiger herzustellen sind als Glassubstrate. Insbesondere können Thermoplaste durch Heißprägen oder Spritzgießen verarbeitet werden und für die Anwendung als Biochip notwendige Mikrostrukturen können unmittelbar abgeformt werden.

Der Erfindung liegt die Aufgabe zugrunde, ein Verfahren zur Herstellung einer optischen Wellenleiterschicht auf einem Substrat anzugeben, das die Herstellung qualitativ hochwertiger Wellenleiterschichten mit geringer Dämpfung auch auf temperaturempfindlichen Substraten, insbesondere Kunststoffsubstraten, ermöglicht.

Diese Aufgabe wird durch ein Verfahren mit den Merkmalen des Patentanspruchs 1 gelöst. Vorteilhafte Ausgestaltungen und Weiterbildungen der Erfindung sind Gegenstand der abhängigen Ansprüche.

Gemäß zumindest einer Ausgestaltung des Verfahrens zur Herstellung einer optischen Wellenleiterschicht wird ein Substrat bereitgestellt, und eine erste Teilschicht der Wellenleiterschicht auf das Substrat aufgewachsen. Nachfolgend wird eine zweite Teilschicht der Wellenleiterschicht, die aus dem gleichen Material wie die erste Teilschicht gebildet ist, auf die erste Teilschicht aufgewachsen, wobei die zweite Teilschicht während des Aufwachsens mit Ionen beschossen wird.

Das Aufwachsen der optischen Wellenleiterschicht auf das Substrat erfolgt also in zwei Teilschritten. Bei dem ersten Teilschritt des Verfahrens wird eine erste Teilschicht der Wellenleiterschicht auf das Substrat aufgebracht, die während des Aufwachsens vorteilhaft nicht mit Ionen beschossen wird. Auf diese Weise wird eine Schädigung des Substrats, insbesondere eines Kunststoffsubstrats, durch Ionenbeschuss und eine eventuell dadurch bedingte zu starke Erhöhung der Temperatur an der Substratoberfläche verhindert. Erst bei dem zweiten Verfahrensschritt, bei dem die zweite Teilschicht der Wellenleiterschicht aus dem gleichen Material wie die erste Teilschicht aufgewachsen wird, erfolgt ein Energieeintrag in die aufwachsende zweite Teilschicht durch Ionenbeschuss. Durch den Energieeintrag in die aufwachsende Schicht mittels des Ionenbeschusses wird eine hohe Schichtqualität erzielt, so dass auf diese Weise eine optische Wellenleiterschicht mit einer geringen Dämpfung hergestellt werden kann. Insbesondere können auf verschiedenen Substratmaterialien Dämpfungswerte von weniger als 5 dB, bevorzugt weniger als 3 dB, erreicht werden. Weiterhin zeichnet sich ein auf diese Weise hergestellter Verbund aus Substrat und optischer Wellenleiterschicht durch eine geringe Eigenfluoreszenz aus.

Bevorzugt weisen die Ionen, mit denen die zweite Teilschicht beim Aufwachsen beschossen wird, eine Energie zwischen einschließlich 50 eV und einschließlich 90 eV auf. Mit einer Ionenenergie in diesem Bereich wird eine gute Schichtqualität erzielt, insbesondere wird die aufwachsende Schicht durch den Ionenbeschuss verdichtet, so dass eine Wellenleiterschicht mit geringer Dämpfung erzeugt werden kann. Die Ionenenergie ist aber andererseits noch derart gering, dass keine Schädigung des Substrats durch den Ionenbeschuss oder eine zu starke Erhöhung der Substrattemperatur auftritt.

Die Ionen, mit denen die zweite Teilschicht während des Aufwachsens beschossen wird, können insbesondere Argonionen oder Sauerstoffionen sein.

Bevorzugt beträgt die Temperatur des Substrats während des Aufwachsens der ersten Teilschicht und der zweiten Teilschicht nicht mehr als 80 °C. Besonders bevorzugt beträgt die Temperatur des Substrats während des Aufwachsens der beiden Teilschichten der Wellenleiterschicht sogar nicht mehr als 60 °C.

Das Verfahren ist daher insbesondere für das Aufwachsen einer optischen Wellenleiterschicht auf einem temperaturempfindlichen Substrat geeignet. Insbesondere kann es sich bei dem Substrat um ein Polymersubstrat handeln. Bevorzugt weist das Substrat ein Cycloolefinpolymer auf. Cycloolefinpolymere zeichnen sich durch insbesondere durch eine geringe Eigenfluoreszenz auf, was vorteilhaft für optische Messverfahren in Anwendungen von Biochips ist. Beispiele für Cycloolefinpolymere sind insbesondere Zeonex und Zeonor. Derartige Cycloolefinpolymere sind temperaturempfindlich und lassen sich daher mit herkömmlichen Beschichtungsverfahren nicht ohne weiteres mit einer optischen Wellenleiterschicht beschichten.

Die Wellenleiterschicht, die die zwei nacheinander aufgebrachten Teilschichten umfasst, besteht vorzugsweise aus einem anorganischen Material. Insbesondere kann die Wellenleiterschicht Tantalpentoxid (Ta₂O₅) enthalten oder daraus bestehen. Tantalpentoxid ist aufgrund seines vergleichsweise hohen Brechungsindex und seiner Transparenz gut als Material für optische Wellenleiterschichten geeignet.

Die erste Teilschicht der Wellenleiterschicht, die vorteilhaft ohne Ionenbeschuss hergestellt wird, weist bevorzugt eine Dicke von mindestens 5 nm, besonders bevorzugt von mindestens 10 nm auf. Auf diese Weise wird erreicht, dass die erste Teilschicht das darunter liegende Substrat beim Aufwachsen der zweiten Teilschicht vor dem Ionenbeschuss schützt.

Weiterhin ist es vorteilhaft, wenn die zweite Teilschicht dicker als die erste Teilschicht ist, so dass der überwiegende Teil der Wellenleiterschicht unter Energieeintrag mittels Ionenbeschuss hergestellt wird. Auf diese Weise wird eine hohe Schichtqualität und somit eine Wellenleiterschicht mit geringer optischer Dämpfung erzielt. Die Dicke der ersten Teilschicht, die ohne Ionenbeschuss hergestellt wird, wird vorteilhaft so gewählt, dass sie gerade ausreicht, um das Substrat vor dem Ionenbeschuss beim Aufwachsen der zweiten Teilschicht zu schützen. Bevorzugt ist die zweite Teilschicht mindestens zehnmal so dick wie die erste Teilschicht. Die zweite Teilschicht kann insbesondere eine Dicke von 100 nm oder mehr aufweisen.

Das Aufwachsen der ersten Teilschicht der Wellenleiterschicht erfolgt vorzugsweise durch thermische Verdampfung. Insbesondere hat es sich als vorteilhaft herausgestellt, die erste Teilschicht der Wellenleiterschicht nicht durch Elektronenstrahlverdampfung aufzuwachsen, weil sich in diesem Fall eine höhere Eigenfluoreszenz für das Substrat mit der aufgebrachten Wellenleiterschicht ergeben würde als im Fall einer rein thermischen Verdampfung.

Das Aufwachsen der zweiten Teilschicht kann durch thermische Verdampfung und/oder Elektronenstrahlverdampfung erfolgen. Bevorzugt wird die zweite Teilschicht wie die erste Teilschicht nur durch thermische Verdampfung aufgewachsen.

Die mittels des vorliegenden Verfahrens hergestellten optischen Wellenleiterschichten zeichnen sich durch eine gute Haftfestigkeit sowie eine gute Temperaturbeständigkeit im Bereich von - 25 °C bis + 60 °C aus. Weiterhin weisen die Wellenleiterschichten eine hohe Beständigkeit gegenüber polaren Lösungsmitteln auf.

Die Erfindung wird im Folgenden anhand eines Ausführungsbeispiels im Zusammenhang mit den Figuren 1 bis 3 näher erläutert.

Es zeigen:
Figur 1 eine schematische Darstellung eines ersten Zwischenschritts bei einem Ausführungsbeispiel des Verfahrens zur Herstellung einer optischen Wellenleiterschicht,
Figur 2 eine schematische Darstellung eines zweiten Zwischenschritts bei einem Ausführungsbeispiel des Verfahrens zur Herstellung einer optischen Wellenleiterschicht, und
Figur 3 eine schematische Darstellung eines Querschnitts durch ein Ausführungsbeispiel der mit dem Verfahren hergestellten optischen Wellenleiterschicht.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

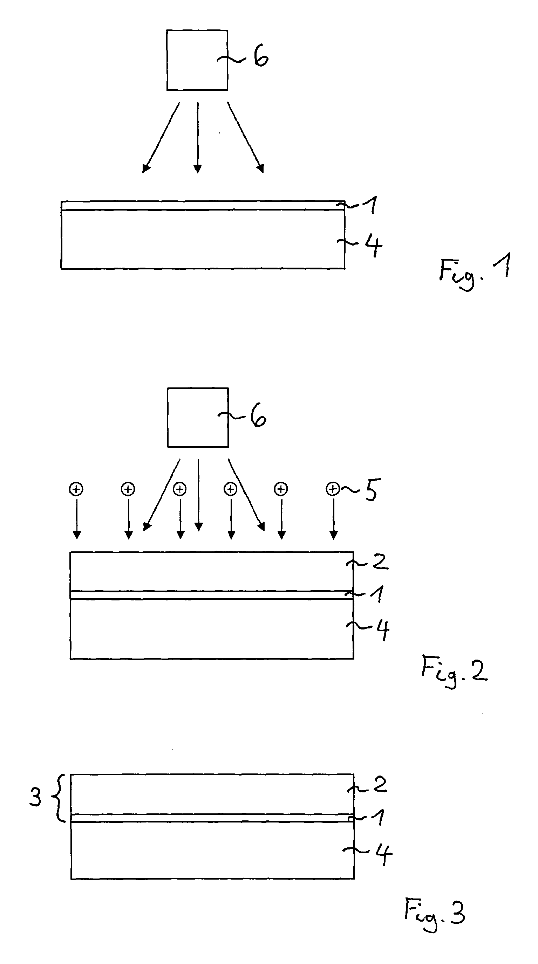

Bei dem in Figur 1 dargestellten ersten Zwischenschritt des Ausführungsbeispiels eines Verfahrens zur Herstellung einer optischen Wellenleiterschicht wird eine erste Teilschicht 1 der optischen Wellenleiterschicht auf ein Substrat 4 aufgewachsen.

Bei dem Substrat 4 handelt es sich bevorzugt um ein Polymersubstrat. Insbesondere kann es sich bei dem Polymersubstrat 4 um ein Substrat aus einem Cycloolefinpolymer handeln, da sich Cycloolefinpolymere durch eine geringe Eigenfluoreszenz auszeichnen, die vorteilhaft für die Anwendung in Biochips ist.

Die optische Wellenleiterschicht, von der bei dem in Figur 1 dargestellten ersten Zwischenschritt die erste Teilschicht 1 aufgebracht wird, wird vorzugsweise aus einem anorganischen Material hergestellt. Insbesondere kann die optische Wellenleiterschicht Ta₂O₅ aufweisen oder daraus bestehen.

Das Material der ersten Teilschicht 1 wird vorzugsweise aus einer Verdampfungsquelle 6, wie durch die Pfeile angedeutet, auf das Substrat 4 aufgebracht. Der Beschichtungsprozess wird vorteilhaft in einer Hochvakuum-Beschichtungsanlage durchgeführt, insbesondere in einer Beschichtungsanlage, die eine plasmaionengestützte Verdampfung (PIAD - plasma ion assisted deposition) ermöglicht. Bei dem Beschichtungsprozess wird die Anlage vorteilhaft in einen Druckbereich von weniger als 1 x 10⁻⁶ mbar evakuiert.

In der Verdampfungsquelle 6 wird das aufzubringende Material insbesondere aus einem Tiegel, zum Beispiel einem Wolfram-Schiffchen, verdampft. Dazu wird der Tiegel beispielsweise mittels Widerstandsheizung beheizt.

Die erste Teilschicht 1 wird mittels thermischer Verdampfung vorzugsweise mit einer Dicke von mindestens 5 nm auf das Substrat 4 aufgewachsen. Beispielsweise kann die erste Teilschicht 1 eine Dicke von etwa 10 nm aufweisen.

Bei dem in Figur 2 dargestellten zweiten Zwischenschritt des Verfahrens wird eine zweite Teilschicht der optischen Wellenleiterschicht auf die erste Teilschicht 1 aufgewachsen. Die zweite Teilschicht 2 wird aus dem gleichen Material wie die erste Teilschicht 1 hergestellt, insbesondere aus einem anorganischen Material wie beispielsweise Ta₂O₅. Im Gegensatz zur ersten Teilschicht 1 wird die zweite Teilschicht 2 beim Aufwachsen vorteilhaft mit Ionen 5 beschossen.

Der Ionenbeschuss erfolgt aus einer Plasma-Ionenquelle (nicht dargestellt). Eine geeignete Plasma-Ionenquelle ist beispielsweise die Plasma-Ionenquelle APS (Advanced Plasma Source) der Firma Leybold Optics. Die Ionen werden mittels einer einstellbaren Bias-Spannung in Richtung des Substrats beschleunigt 4. Bevorzugt wird eine Bias-Spannung von 50 V bis 90 V eingestellt, um das Substrat mit Ionenenergien von 50 eV bis 90 eV zu beschießen. Insbesondere kann für die Bias-Spannung ein Wert von 80 V eingestellt werden.

Bei den Ionen 5 kann es sich insbesondere um Argon- und/oder Sauerstoffionen handeln. Zur Erzeugung der Ionen werden der Plasmaionenquelle Argongas und Sauerstoffgas zugeführt, beispielsweise Argon mit einer Flussrate von 14 sccm und Sauerstoff mit einer Flussrate von 20 sccm.

Das Substrat 4 ist während des Aufwachsens der zweiten Teilschicht 2 durch die zuvor aufgebrachte erste Teilschicht 1 vor dem Ionenbeschuss geschützt. Weiterhin erhöht sich auch die Temperatur des Substrats während des Beschichtungsprozesses nur geringfügig, so dass das Substrat auch nicht durch eine erhöhte Temperatur geschädigt wird. Beispielsweise wurde an dem Substrat 4 zu Beginn des Beschichtungsprozesses eine Temperatur von 28 °C und am Ende eine Temperatur von 55 °C gemessen.

Die zweite Teilschicht 2 kann wie die erste Teilschicht 1 durch thermische Verdampfung aus einem Tiegel, beispielsweise einem Wolfram-Schiffchen erfolgen. Alternativ kann das Aufwachsen der zweiten Teilschicht 2 auch mit Elektronenstrahlverdampfung erfolgen. Bevorzugt werden aber sowohl die erste Teilschicht 1 als auch die zweite Teilschicht 2 jeweils mit thermischer Verdampfung abgeschieden.

Die Dicke der zweiten Teilschicht 2 ist vorzugsweise größer als die Dicke der ersten Teilschicht 1. Insbesondere kann die zweite Teilschicht 2 mindestens zehnmal so dick sein wie die erste Teilschicht 1. Beispielsweise kann die erste Teilschicht 1 mit einer Dicke von etwa 10 nm und die zweite Teilschicht 2 mit einer Dicke von mehr als 100 nm aufgebracht werden. Die Aufwachsrate kann zum Beispiel 0,23 nm/s betragen. Durch den Ionenbeschuss der zweiten Teilschicht 2 während des Aufwachsens wird eine vergleichsweise dichte Schicht erzielt, die sich durch eine geringe Dämpfung von 5 dB oder weniger auszeichnet.

In Figur 3 ist die fertig hergestellte optische Wellenleiterschicht 3, die die erste Teilschicht 1 und die zweite Teilschicht 2 umfasst, mit dem darunter liegenden Substrat 4 im Querschnitt dargestellt. Die Gesamtdicke der optischen Wellenleiterschicht kann beispielsweise etwa 150 nm betragen. Eine mit dem zuvor beschriebenen Verfahren hergestellte Probe aus dem Substrat 4 mit der darauf aufgebrachten Wellenleiterschicht 3 zeichnete sich durch eine um etwa 50 Prozent geringere Fluoreszenz eine mit herkömmlicher plasmaionengestützter Elektronenstrahlverdampfung hergestellte Probe aus. Weiterhin wies die mit dem beschriebenen Verfahren hergestellte optische Wellenleiterschicht 3 einen Dämpfungswert von nur etwa 4 dB für rotes Laserlicht mit einer Wellenlänge von 633 nm auf.

Das Verfahren ist also insbesondere zur Herstellung von optischen Wellenleiterschichten mit niedriger Dämpfung auf temperaturempfindlichen Substraten geeignet.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Verfahren zur Herstellung einer optischen Wellenleiterschicht (3) mit den Verfahrensschritten:
- Bereitstellen eines Substrats (4),
- Aufwachsen einer ersten Teilschicht (1) der Wellenleiterschicht (3) auf das Substrat (4),
- Aufwachsen einer zweiten Teilschicht (2) der Wellenleiterschicht (3), die aus dem gleichen Material wie die erste Teilschicht (1) gebildet ist, auf die erste Teilschicht (1), wobei die zweite Teilschicht (2) während des Aufwachsens mit Ionen beschossen wird.

2. Verfahren zur Herstellung einer optischen Wellenleiterschicht nach Anspruch 1,
wobei die Ionen (5) mit denen die zweite Teilschicht (2) beim Aufwachsen beschossen wird, eine Energie von 50 eV bis 90 eV aufweisen.

3. Verfahren zur Herstellung einer optischen Wellenleiterschicht nach einem der vorhergehenden Ansprüche,
wobei die Ionen (5) Argonionen und/oder Sauerstoffionen sind.

4. Verfahren zur Herstellung einer optischen Wellenleiterschicht nach einem der vorhergehenden Ansprüche,
wobei die Temperatur des Substrats (4) während des Aufwachsens der ersten Teilschicht (1) und der zweiten Teilschicht (2) nicht mehr als 80 °C beträgt.

5. Verfahren zur Herstellung einer optischen Wellenleiterschicht nach Anspruch 3,
wobei die Temperatur des Substrats (4) während des Aufwachsens der ersten Teilschicht (1) und der zweiten Teilschicht (2) nicht mehr als 60 °C beträgt.

6. Verfahren zur Herstellung einer optischen Wellenleiterschicht nach einem der vorhergehenden Ansprüche,
wobei das Substrat (4) ein Polymersubstrat ist.

7. Verfahren zur Herstellung einer optischen Wellenleiterschicht nach Anspruch 6,
wobei das Substrat (4) ein Cycloolefinpolymer aufweist.

8. Verfahren zur Herstellung einer optischen Wellenleiterschicht nach einem der vorhergehenden Ansprüche,
wobei die Wellenleiterschicht aus einem anorganischen Material hergestellt wird.

9. Verfahren zur Herstellung einer optischen Wellenleiterschicht nach einem der vorhergehenden Ansprüche,
wobei die Wellenleiterschicht (3) Tantalpentoxid enthält.

10. Verfahren zur Herstellung einer optischen Wellenleiterschicht nach einem der vorhergehenden Ansprüche,
wobei die erste Teilschicht (1) eine Dicke von mindestens 5 nm aufweist.

11. Verfahren zur Herstellung einer optischen Wellenleiterschicht nach einem der vorhergehenden Ansprüche,
wobei die zweite Teilschicht (2) dicker als die erste Teilschicht (1) ist.

12. Verfahren zur Herstellung einer optischen Wellenleiterschicht nach Anspruch 11,
wobei die zweite Teilschicht (2) mindestens zehnmal so dick wie die erste Teilschicht (1) ist.

13. Verfahren zur Herstellung einer optischen Wellenleiterschicht nach einem der vorhergehenden Ansprüche,
wobei die zweite Teilschicht (2) mindestens 100 nm dick ist.

14. Verfahren zur Herstellung einer optischen Wellenleiterschicht nach einem der vorhergehenden Ansprüche,
wobei das Aufwachsen der ersten Teilschicht (1) durch thermische Verdampfung erfolgt.

15. Verfahren zur Herstellung einer optischen Wellenleiterschicht nach einem der vorhergehenden Ansprüche,
wobei das Aufwachsen der zweiten Teilschicht (2) durch thermische Verdampfung und/oder Elektronenstrahlverdampfung erfolgt.
